# EUROPEAN PATENT APPLICATION

(11) **EP 0 993 045 A1**
(43) Date of publication of application: **12.04.2000**
(21) Application number: 99307549.8
(22) Date of filing: 24.09.1999
(51) Int. Cl.: H01L 23/64

(54) **Integrated circuit die with directly coupled noise suppression**

(30) Priority: 07.10.1998 US 168310
(71) Applicant: Hewlett-Packard Company, Palo Alto, California 94304 (US)
(72) Inventor: Bledsoe, J. Daren, Albany, OR 97321 (US); McKinley, Patrick A., Corvallis, OR 97330 (US); Croft, Daniel I., Monmouth, OR 97361 (US)
(74) Representative: Colgan, Stephen James

(57) **Abstract**

An integrated circuit die (20,120,220) having EMI suppression and/or other devices (50-54,150,155-159,250) surface mounted thereon. EMI suppression devices such as capacitors are disclosed that are direct chip attach mounted to integrated circuit dies through vias to the redistribution layers (30, 130,230) or through vias directly to the circuitry (24,124). Similarly mounted or otherwise provided resistors, inductors and other circuit devices (50-54,150,155-159,200) are also disclosed.

## Description

### FIELD OF THE INVENTION

The present invention relates to noise suppression in integrated circuits and to the mounting of ancillary circuit components more closely to integrated circuit dies.

### BACKGROUND OF THE INVENTION

As the number of transistors per unit area and the speed at which these transistors are switched increases, so does the electromagnetic interference (EMI) and other noise associated with such transitions. EMI and related noise are generally referred to herein as "EMI." EMI is often coupled to power and ground lines (and to signal lines) on a die and then propagated off the die to the printed circuit assembly or the like. Deleterious effects of EMI include signal corruption and expensive EMI compensation to comply with FCC product requirements, amongst other effects.

In an effort to suppress EMI, printed circuit boards and printed circuit assemblies often have a plurality of capacitors provided thereon. These capacitors may be coupled between power and ground conductors and/or between signal and ground conductors. While these capacitors are useful to some extent in reducing EMI, the provision of capacitors on printed circuit assemblies is disadvantageous in that the capacitors are placed at a considerable distance from the on-chip source of the EMI. EMI suppression at a distance is disadvantageous for many reasons including that (1) the additional conductor lengths act as antennas and (2) signal reflection is exacerbated by longer conductor lengths.

Prior art efforts to suppress EMI also include the formation of capacitors within semiconductive die material using standard photolithographic formation techniques. While these capacitors have demonstrated some degree of EMI suppression, they are disadvantageous in that they take up valuable die real estate, they do not provide sufficient suppression and they are relatively expensive.

### SUMMARY OF THE INVENTION

Accordingly, it is an object of the present invention to improve integrated circuit performance by reducing EMI generated by an integrated circuit die.

It is another object of the present invention to provide such EMI suppression at a location that is close to the source of EMI generation.

It is another object of the present invention to contain EMI on an integral circuit die and to minimize its propagation off-die to the printed circuit assembly.

It is also an object of the present invention to couple an EMI suppression mechanism directly to an integrated circuit die to achieve relatively immediate EMI suppression.

These and related objects of the present invention are achieved by use of a integrated circuit die with directly coupled noise suppression and/or other device as described herein.

The attainment of the foregoing and related advantages and features of the invention should be more readily apparent to those skilled in the art, after review of the following more detailed description of the invention taken together with the drawings.

### BRIEF DESCRIPTION OF THE DRAWINGS

Fig. 1 is an embodiment of an integrated circuit die having noise suppression and/or other devices coupled thereto in accordance with the present invention.

Fig. 2 is a cross sectional view of an alternative embodiment of an integrated circuit die with noise suppression and/or other devices mounted thereto in accordance with the present invention.

Fig. 3 is a side view of a noise suppressing capacitor or other circuit component that is direct chip attach mounted to an integrated circuit die in accordance with the present invention.

### DETAILED DESCRIPTION

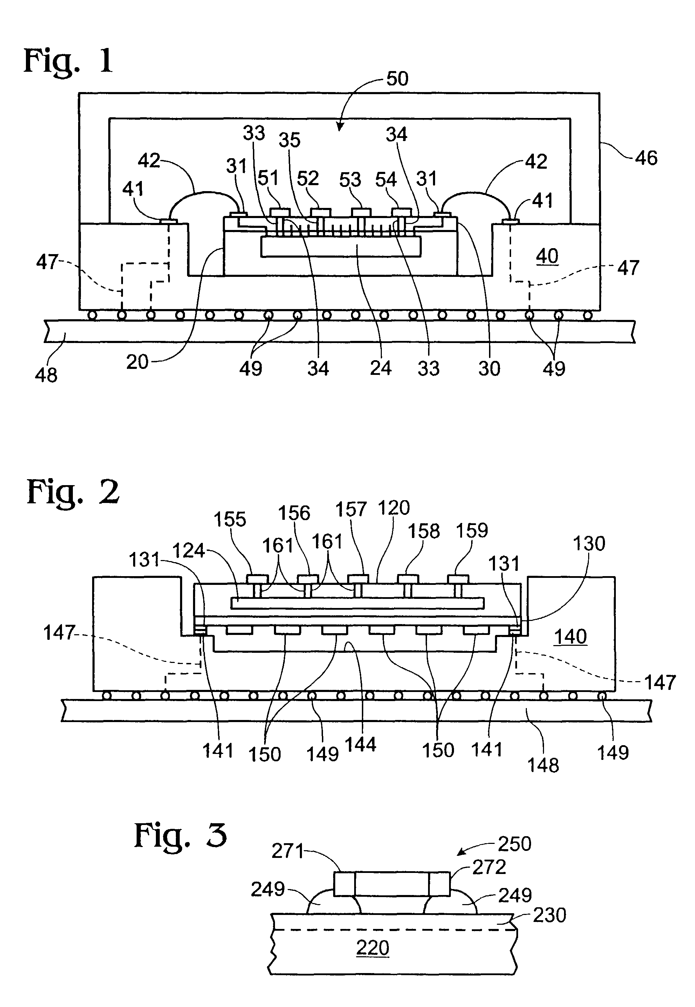

Referring to Fig. 1, an embodiment of an integrated circuit die 20 having noise suppression and/or other devices 50 coupled thereto in accordance with the present invention is shown. Integrated circuit die 20 (hereinafter referred to as "die 20") is preferably formed of a semiconductive material such as silicon or another suitable semiconductive material. A plurality of transistors and other circuit components are formed in the semiconductive material to create an integrated circuit. The transistors and other circuit components are generally referred to as "circuit components 24". Formation of circuit components in semiconductive material is well known in the art.

In order to facilitate the input and output of signals to or from a die, various mounting packages 40 have been developed. These include ball grid arrays, quad flat packs and plastic leaded chip carriers, amongst other industry packages. These packages are typically mounted in a low impedance manner (e.g. conductive balls 49) to a printed circuit assembly 48. Fig. 1 illustrates die 20 glued within a representative package 40 with wire bonds 42 connecting the contact pads 31 of the die to the contact pads 41 of the package. The contact pads of the package are internally connected (shown by dashed line 47) to one or more conductive balls 49. While only two bond wires 42 are shown in the cross-sectional perspective of Fig. 1, a plurality of bond wires are preferably provided about the periphery of the die as is known.

A top layer of die 20 is a redistribution layer 30. The concept of a redistribution layer is known in the art. Conventional redistribution layers, as the name implies, are used to distribute (or redistribute) signal traces from circuit components 24 to contact pads 31. Power and ground are also often distributed through the redistribution layer 30.

In one embodiment, the present invention provides noise suppression devices 50 coupled directly to the die, i.e., to the redistribution layer of the die. These EMI suppression devices are electrically coupled to signal traces within the redistribution layer (or elsewhere in the die) as discussed in more detail below. The EMI suppression devices are preferably capacitors of sufficient magnitude to achieve desired EMI suppression. More specifically, the capacitors are preferably in the range of 0.01pf to 0.1µf, though other capacitor values may be implemented.

Capacitors 50 are preferably made of ceramic or plastic, though they may be made of any suitable capacitive material. Ceramic capacitors are more thermally stable and thus their use is likely to reduce problems associated with different thermal coefficients of expansion. Suitable capacitors are available commercially. Capacitors 50 are preferably mounted to the redistribution layer using standard surface mounting techniques and reflow solder attachment procedures, though all types of suitable capacitor attachment methods are within the present invention. To reduce parasitics and inherent impedance, flip mounting, solder bump mounting or another direct chip attachment technique is preferably utilized. Capacitor attachment is discussed in more detail below with reference to Fig. 3.

Representative power conductors 33 and representative ground connectors 34 are shown in the redistribution layer and coupled to circuit componentry 24. Two pairs of power and ground conductors are shown coupled to capacitors 51 and 54, respectively. Capacitor 52 is coupled between a signal line 35 and ground. Capacitor 53 is coupled between two arbitrary representative signal traces.

Once a plurality of capacitors has been coupled to the die in their appropriate positions, and the die is mounted and electrically coupled to package 40, standard finishing steps are preferably performed. These include application of an insulation material over the exposed electrical conductors, capacitors and die, and placement of a cap 46 over this structure as is known.

Referring to Fig. 2, a cross sectional view of an alternative embodiment of an integrated circuit die 120 with noise suppression and/or other devices mounted thereto in accordance with the present invention is shown. Similar to die 20 of Fig. 1, die 120 of Fig. 2 includes circuit componentry 124 and a redistribution layer 130. Contact pads 131 are provided for coupling to contact pads 141 of package 140 which in turn are coupled through internal conducts 147 through bumps 149 to the printed circuit assembly 148. A plurality of EMI suppressing capacitors 150 are preferably coupled to redistribution layer 130 in the manner described with reference to Figs. 1 and 3. A recess 144 may be provided in package 140 to accommodate the capacitors.

Fig. 2 also shows the formation of capacitors 155-159 on another surface of die 120. These capacitors are connected by vias 161 and provide direct attachment of a noise suppression device to die 120 and circuit components 124 other than through redistribution layer 130. Capacitors 155-159 respectively couple power and ground, a signal line and ground, power and ground, a signal line to ground and power to ground.

Referring to Fig. 3, a side view of a noise suppressing capacitor 250 (or a resistor, inductor or other surface mount circuit component as discussed in more detail below) that is surface mounted using direct chip attach to an integrated circuit die 220 in accordance with the present invention is shown. Capacitor 250 is specifically representative of one particular embodiment of capacitors 50 and 150 (i.e., capacitors 51-54, 155-159, etc.) and generally representative of a direct mounting of a capacitor, resistor, inductor or other circuit component to an integrated circuit die. As a capacitor, device 250 is preferably a ceramic capacitor with metalized ends 271, 272. These ends are direct chip attach mounted through solder bumps 249 to die 220 or to the redistribution 230 layer (shown in phantom lines) of die 220.

While the direct attachment of capacitors to a semiconductor die for EMI suppression is beneficial as discussed herein, it should be recognized that one or more of the capacitor 50, 51-54, 150, 155-159 could be replaced or supplemented with a resistor or inductor or other surface mount component. These resistors, inductors or other surface mount components would be connected to the die in the same manner as discussed herein for the capacitors. The provision of resistors and/or inductors in this manner permits the formation of filter circuits and other types of circuit directly on a die. The provision of these circuits in turn achieves the benefits of close placement discussed herein and permits more compact circuit and printed circuit assembly design, amongst other benefits.

While the invention has been described in connection with specific embodiments thereof, it will be understood that it is capable of further modification, and this application is intended to cover any variations, uses, or adaptations of the invention following, in general, the principles of the invention and including such departures from the present disclosure as come within known or customary practice in the art to which the invention pertains and as may be applied to the essential features hereinbefore set forth, and as fall within the scope of the invention and the limits of the appended claims.

## Claims

1. An integrated circuit assembly, comprising:
a semiconductive substrate (20,120,220);
a circuit component (24,124) formed in said semiconductive substrate (20,120,220); and
a first electronic device (50-54,150,155-159,250) surface mounted on said substrate that is electrically coupled through said substrate to said circuit component (24,124).

2. The assembly of claim 1, wherein said first electronic device is one of the group of electronic devices including an inductor (250), a resistor (250) and a capacitor (50-54,150,155-159,250).

3. The assembly of claim 1, wherein said first electronic device is an EMI suppression device (50-54,150,155-159,250).

4. The assembly of claim 1, wherein said substrate includes a redistribution layer (30,130,230) disposed towards a surface of said substrate and said first electronic device is provided on said redistribution layer.

5. The apparatus of claim 1, wherein said first electronic device is direct chip attach mounted to said substrate.

6. The assembly of claim 1, wherein said substrate further comprises a non-ground conductor (33) and a ground conductor (34) that respectively provide a non-ground signal and a ground signal to said circuit componentry (24,124); and
wherein said first electronic device (51,54) is coupled between said non-ground and said ground conductor.

7. The assembly of claim 1, further comprising a second electronic device (50-54,150,155-159,250) that is surface mounted on said substrate and electrically coupled to said circuit component (24,124);
wherein said first and said second electronic devices are different types of devices.

8. A method of forming an integrated circuit assembly, comprising the steps of:
providing an integrated circuit substrate (20,120,220) that has a circuit component (24,124) formed therein and a plurality of conductors (33,34,35) coupling said circuit component to a surface of said substrate; and
mounting an electronic device (50-54,150,155-159,250) on said substrate in such a manner that said electronic device is electrically coupled to at least two of said plurality of conductors.

9. The method of claim 8, further comprising the step of providing as said electronic device one of the group of electronic devices including a resistor, a capacitor and an inductor.

10. The method of claim 9, wherein said mounting step includes the step of direct chip attach mounting of said electronic device to said substrate.
